# EUROPÄISCHE PATENTSCHRIFT

(11) **EP 0 717 370 B1**
(45) Veröffentlichungstag und Bekanntmachung des Hinweises auf die Patenterteilung: **17.10.2001**
(21) Anmeldenummer: 95119841.5
(22) Anmeldetag: 15.12.1995
(51) Int. Cl.: G06K 19/077

(54) **Verfahren zum Verkappen eines Chipkartenmoduls und Vorrichtung zum Durchführen des Verfahrens**
Method of encapsulating a chipcard module and device for performing the method
Méthode d'encapsulage d'un module et dispositif pour la mise en oeuvre de la méthode

(30) Priorität: 15.12.1994 DE 4444812
(43) Veröffentlichungstag der Anmeldung: 19.06.1996
(73) Patentinhaber: ODS Landis & Gyr GmbH & Co. KG, 85375 Neufahrn (DE)
(72) Erfinder: Schmidt, Frank-Thomas, Dr.-Dipl.-Chem., D-99891 Fischbach (DE); Schlöffel, Lutz, Dipl.-Ing., D-99846 Seebach (DE)
(74) Vertreter: Grünecker, Kinkeldey, Stockmair & Schwanhäusser Anwaltssozietät

(56) Entgegenhaltungen:
- EP-A- 0 390 046
- US-A- 4 962 415
- PATENT ABSTRACTS OF JAPAN vol. 009, no. 312 (P-411), 7.Dezember 1985 & JP 60 142488 A (DAINIPPON INSATSU KK), 27.Juli 1985,
- PATENT ABSTRACTS OF JAPAN vol. 009, no. 230 (E-343), 17.September 1985 & JP 60 086850 A (DAINIPPON INSATSU KK), 16.Mai 1985,

## Beschreibung

Die Erfindung betrifft ein Verfahren gemäß Oberbegriff des Patentanspruchs 1 sowie eine Vorrichtung gemäß Oberbegriff des Patentanspruchs 5.

Passive und aktive Chipkarten mit wenigstens einem Speicher- und/oder Mikroprozessor-Chip werden in zunehmendem Maß verwendet, z.B. als Telefonkarten. Bei der Herstellung der Chipkarte wird ein verkappter Chipkartenmodul in eine Vertiefung eines Chipkartenkörpers eingesetzt und darin befestigt. Um einen Datenverlust oder eine Zerstörung der Chipkarten durch äußere Einflüsse zu vermeiden, müssen die fertigen Chipkarten strengen Prüfungen standhalten. Beispielsweise wird die mechanische Festigkeit durch Biegeversuche mit längsseitigen und breitseitigen Auslenkungen und Verdrehungen geprüft. Typische Ausfälle sind ein Bruch des Trägers des IC-Bausteins, ein Lösen des Chipkarten-Moduls aus der Verbindung mit dem Chipkartenkörper oder ein Bruch des IC-Bausteins. Die mechanische Belastbarkeit der Chipkarte wird deshalb unter anderen durch die die Verkappung bildende Vergießmasse und die Qualität des Verbindungsbereichs zwischen dem Chipkartenmodul und der Chipkarte bestimmt. Für die Qualität des Verbindungsbereichs ist es wichtig, daß der verkappte Chipkartenmodul keinesfalls eine vorbestimmte Höchstdicke überschreitet, damit er mit der Verkappung genau in die Vertiefung des Chipkartenkörpers paßt und ordnungsgemäß festlegbar ist, ohne mit der Kontaktoberfläche über die benachbarte Oberfläche vorzustehen oder dieser gegenüber zurückzutreten. Die Verkappung muß deshalb eine bestimmte Form, eine bestimmte Größe und eine gute Haftung zum Träger aufweisen und soll in Massenfertigung mit gleichbleibender Form und Größe herstellbar sein.

Bei einem aus JP 83 02 50997/JP 601 42488 bekannten Verfahren wird zum Herstellen der Verkappung ein stabiler Rahmen auf dem Träger des Moduls befestigt, der die Form der Verkappung vorgibt. Dann wird flüssiges Epoxid-Harz in den Rahmen gegossen. Durchgangsbohrungen des Trägers werden zunächst durch hochviskoses Epoxid-Harz abgedeckt, damit später eingegossenes niedrigviskoses Epoxid-Harz am Durchlaufen zur unteren Seite des Trägers bzw. zum Leitermuster gehindert wird. Das Harz wird durch thermische Behandlung gehärtet. Die Hitzeinwirkung kann für einzelne Komponenten des Moduls schädlich sein. Ferner wird beim Abdecken der Durchgangsbohrungen in Abhängigkeit von den Verfahrensbedingungen eine größere oder kleinere Menge des Harzes eindringen, so daß die für die Größe und Form der Verkappung voreingestellte Dosis des Harzes nicht immer die richtige ist. Die Temperaturerhöhung zum Härten des Harzes bewirkt nämlich eine Änderung der Viskosität des Harzes. Diese Änderung macht sich im Bereich der Durchgangsbohrungen in Abhängigkeit davon bemerkbar, zu welchem Zeitpunkt die Erwärmung an der Stelle der jeweiligen Durchgangsbohrung wirkt.

Bei einem aus EP-A-0 390 046 bekannten Verfahren ist das Anhaften eines Halbleiterelementes an eine Leiterplatte aus Quarzglas das Halbleiterelement aufgeklebt, um Kontaktstellen miteinander zu koppeln und das Halbleiterelement festzulegen. Dabei wird mit einem Fotosetting-Harz gearbeitet, das durch eine Aussparung einer Arbeitsfläche mit UV-Licht beaufschlagt wird.

Bei einem aus JP 83 01 94889/JP 60 086858 bekannten Verfahren wird der Modul im Inneren einer die Chipkartengröße bestimmenden Form in fotosensitives Harz eingebettet, das zum Festlegen des Moduls im Kartenkörper mit UV-Strahlen zur Aushärtung beaufschlagt wird.

Bei einem aus US-A 4 962 415, Fig. 6, bekannten Verfahren werden die auf einem Trägerstreifen aus einer Vielzahl miteinander verbundener Träger vorpositionierten IC-Bausteine, die über die Leitungen mit der Kontaktoberfläche verbunden sind, mit jeweils einem Tropfen flüssiger Vergießmasse abgedeckt. Die Vergießmasse breitet sich aus und schließt die Leitungen, die sogenannten Bondinseln und gegebenenfalls auch den IC-Baustein ein. Um eine vorbestimmte Dicke des Moduls sicherzustellen, wird die ausgehärtete Vergießmasse gegebenenfalls nachträglich spanabhebend bearbeitet. Der Träger weist konstruktiv bedingte, durchgehende Öffnungen (zum Durchkontaktieren) oder herstellungsbedingte Löcher und Poren (aufgrund der Herstellung und aufgrund Fehlern bei der Herstellung) auf, in die die Vergießmasse im Verkappungsbereich in unkontrollierbarer Weise eindringt, und ggfs. durchläuft. Dies ist in mehrfacher Hinsicht ungünstig. Die Vergießmasse wird nämlich in einer vorherbestimmten Dosis aufgebracht, um eine bestimmte Form und Größe der Verkappung zu erzielen. Durch das unkontrollierbare Eindringen und gegebenenfalls Durchfließen der Vergießmasse entstehen von Fall zu Fall unterschiedlich große oder unterschiedlich geformte Verkappungen. Femer besteht die Gefahr, daß eigentlich einzubettende Komponenten auf dem Modul frei bleiben, weil stellenweise zu viel Vergießmasse wegläuft. Schießlich wird die Kontaktoberfläche durch durchgelaufene Vergießmasse verunreinigt, was eine nachträgliche Säuberung erfordert oder zu hohem Ausschuß führt. Auch wird die Vorrichtung, in der die Module verkappt werden, verschmutzt, was den Arbeitsablauf beeinträchtigt.

Der Erfindung liegt die Aufgabe zugrunde, ein Verfahren der eingangs genannten Art sowie eine Vorrichtung zum Durchführen des Verfahrens anzugeben, bei denen auf einfache Weise die gewünschten Abmessungen der Chipkartenmodule und eine hohe Qualität der Verkappung erreicht und eine Verschmutzung der Kontaktoberfläche mit Vergießmasse vermieden werden.

Die gestellte Aufgabe wird erfindungsgemäß mit dem Verfahren gemäß Anspruch 1 sowie mit der Vorrichtung gemäß Anspruch 5 gelöst.

Verfahrensgemäß werden kostengünstig die vorbestimmten Abmessungen des Chipkartenmoduls auch bei Massenproduktion nachbearbeitungsfrei eingehalten und qualitativ hochwertige Verkappungen gleicher Form und Abmessungen erzeugt. Eine Verschmutzung der Kontaktoberfläche sowie der Vorrichtung unterbleibt, weil die Vergießmasse gehindert wird, in nicht kontrollierbarer Weise durch die Öffnungen im Träger wegzufließen. Die Vergießmasse wird in den Öffnungen durch UV-Bestrahlung so weit verfestigt, daß die Öffnungen verschlossen werden. Dabei werden mit UV-Licht härtbare Vergießmassen verwendet, die sich fast spontan aktivieren lassen, wobei wenig oder (bei Verwendung von Filtern an der Strahlenquelle) fast gar keine Wärme im Verbindungsbereich entsteht, was für den thermoplastischen Chipkartenkörper und den Modul günstig ist. Beim UV-Bestrahlen werden die Öffnungen immer gleich und sehr rasch verschlossen, da für einen sicheren Verschluß der Öffnungen nur geringe Volumina der Vergießmasse bestrahlt zu werden brauchen. Die UV-Bestrahlung kann von der Kontaktoberfläche oder von der Verkappungsseite oder auch von beiden Seiten einwirken. Es kann günstig mit dünnflüssiger Vergießmasse gearbeitet werden. Das UV-Licht hat zweckmäßig keinen Einlfuß auf die Viskosität der Vergießmasse, so daß das Verschließen der Öffnungen jeweils gleich und in der vorbestimmten Weise erfolgen muß. Durch das rasche Verschließen der Öffnungen bleibt die dazu notwendige anteilige Menge der Vergießmasse weitgehend unabhängig von der Größe und der Anzahl der vorhandenen Öffnungen, so daß die grundsätzlich gewählte Gesamtdosis auch bei einer Massenfertigung zu gleichartigen Verkappungen führt. Durch die gesteuerte Einstellung der Drücke wird auch bei dünnflüssiger Vergießmasse deren Durchlaufneigung durch die Öffnung entgegengewirkt. Die Druckeinstellung ist als flankierende Maßnahme zum UV-Bestrahlen und auch im Hinblick darauf wichtig, daß in dieser Technik häufig mit Unterdruck gearbeitet wird, um den Träger beim Verkappen zu positionieren, wobei sich der Unterdruck sich bis an die Kontakt-oberfläche unterhalb des Verkappungsbereiches fortzupflanzen pflegt und dann Vergießmasse verstärkt durch die Öffnungen saugt. Durch Herstellen eines Druckgleichgewichts im Verkappungsbereich oder sogar eines Überdruckes wird dieser Tendenz entgegengewirkt, so daß die UV-Bestrahlung zum Verschließen der Öffnungen in exakt reproduzierbarer Weise und unbeeinflußt von solchen Einflüssen zum Tragen kommt.

In der Vorrichtung wird beim Verkappen durch eine gezielte Strahlungsbehandlung die in die Öffnungen eindringende oder eingedrungene Vergießmasse verfestigt, bis die Öffnungen verschlossen sind. Mit der eingestellten Vergießmassen-Dosis wird die Verkappung mit der vorbestimmten Form und Größe erstellt. Eine Verschmutzung der Kontaktoberfläche oder/und der Auflagefläche wird vermieden. Es lassen sich bei Massenproduktion praktisch identische Verkappungen mit hoher Produk- tionsrate erzeugen, selbst wenn bei kurzer Verweildauer jedes Trägers nicht die gesamte Vergießmasse in der Verkappung ausgehärtet sein sollte. Es läßt sich sehr dünnflüssige und damit rasch und exakt verarbeitbare Vergießmasse benutzen, und zwar auch für Träger, die absichtlich oder zufällig große und/oder viele Öffnungen im Verkappungsbereich besitzen. Über den Belüftungskanal wird entweder der Umgebungsdruck an der Kontaktoberfläche eingestellt, was bei Unterdruck-Niederhaltevorrichtungen zweckmäßig ist, in denen sich der Unterdruck ansonsten bis unterhalb des Verkappungsbereiches fortpflanzen könnte, oder sogar ein Überdruck erzeugt, der das Durchlaufen der Vergießmasse verhindert oder die Vergießmasse zurückdrückt.

Es ist zwar bekannt, Träger mit großen Öffnungen durch Abkleben mit Klebeband vorzubehandeln und das Klebeband nach dem Aushärten der Verkappung wieder zu entfemen. Dies ist jedoch eine für die Massenproduktion nicht akzeptable Vorgangsweise.

Gemäß Anspruch 2 werden zunächst die Öffnungen durch Verfestigen der Vergießmasse verschlossen, ehe mit der zweiten Dosis die Verkappung in ihrer endgültige Größe und Form gebracht wird. Die erste Dosis kann dabei so eingestellt werden, daß entweder nur die Öffnungen zuverlässig verschließbar sind und der Hauptteil der Verkappung mit der zweiten Dosis gebildet wird, oder so, daß mit der ersten Dosis bereits der größte Teil der Verkappung gebildet und mit der zweiten Dosis nur mehr eine Feinabstimmung der Größe und Form der Verkappung vorgenommen wird.

Besonders zweckmäßig ist gemäß Anspruch 3 eine Bestrahlung von der Kontaktoberfläche des Trägers her, weil auf diese Weise dem Ein- und Durchdringen der Vergießmasse durch die Öffnungen rasch entgegengewirkt und die Öffnungen zuverlässig verschlossen werden.

Gemäß Anspruch 4 werden UV-Strahlen angewandt, die für die jeweils eingesetzte Vergießmasse zum raschen Stabilisieren führen und dabei weder den Träger noch die elektronischen Komponenten gefährden.

Die Vorrichtung gemäß Anspruch 6 hat eine einfache Bauform, da die UV-Strahlenquelle unterhalb der Auflagefläche angeordnet ist. Außerdem wird mit der UV-Bestrahlung eine rasche zumindest lokale Verfestigung der Vergießmasse erreicht, was zu kurzen Taktzeiten führt. Eine Verschmutzung der Kontaktoberfläche oder der Auflagefläche durch durchdringende Vergießmasse ist praktisch ausgeschlossen.

Die gemäß Anspruch 7 verwendeten UV-Strahlenquellen arbeiten mit vertretbarem Energieaufwand und gefährden den Träger und die elektronischen Komponenten nicht.

Insbesondere bei Anwendung von Überdruck, z.B. an der Kontrolloberfläche, ist gemäß Anspruch 8 in dem verschlossenen Hohlraum eine gleichbleibende Druckhöhe einzustellen.

Gemäß Anspruch 9 wird eine präzise Positionierung des Trägers beim Verkappen gewährleistet. Selbst wenn die Saugkanäle permanent mit Unterdruck beaufschlagt werden, ist die Kontaktoberfläche unterhalb des Verkappungsbereiches durch den bewußt eingesteuerten Druckausgleich oder den Überdruck von störenden Einflüssen des Unterdrucks der Niederhaltevorrichtung frei.

Gemäß Anspruch 10 wird über die Dosiersteuervorrichtung zunächst nur eine Dosis Vergießmasse abgegegeben, mit der die Öffnungen verschlossen werden. Die endgültige Form und Größe der Verkappung wird mit der zweiten Dosis hergestellt. Es ergeben sich auf diese Weise präzis reproduzierbare Verkappungen in gleicher Form und Größe.

Alternativ werden gemäß Anspruch 11 die Dosen von getrennten Dosierventilen abgegeben. Dabei kann es gemäß Anspruch 12 zweckmäßig sein, zum Verschließen der Öffnungen eine zähflüssigere Vergießmasse oder eine Vergießmasse aufzubringen, die zum raschen und zuverlässigen Verschließen der Öffnungen eingestellt ist, während die zweite Vergießmasse so eingestellt sein kann, daß sich mit ihr die elektronischen Komponenten in der gewünschten Weise einbetten lassen und ideale Formen und Größen der Verkappungen erhalten werden.

(Fortsetzung auf der ursprünglichen Seite 7, mit dem zweiten Absatz, der Beschreibung).

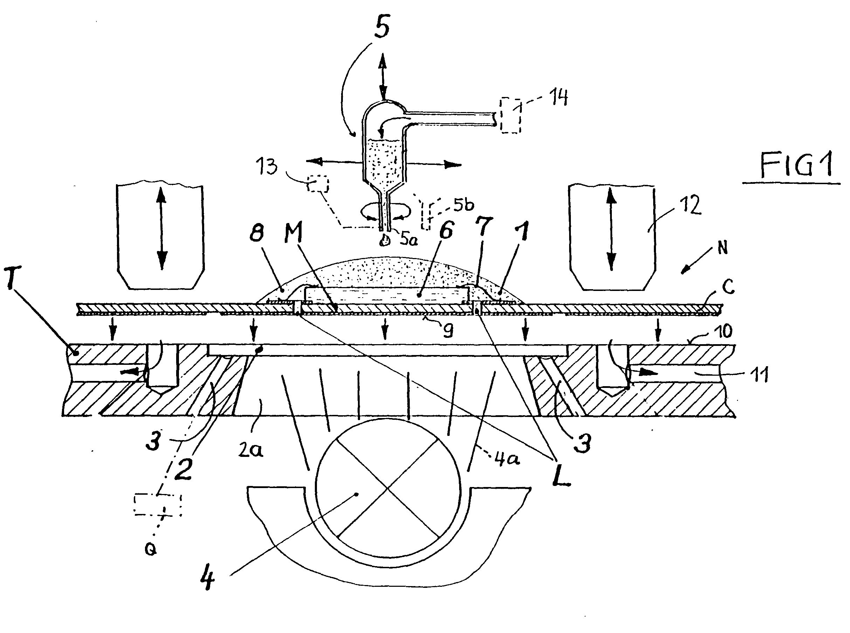

Anhand der Zeichnung werden Ausführungsformen des Erfindungsgegenstandes erläutert. In Fig. 1 ist schematisch in einer Teilschnittansicht eine Vorrichtung zum Verkappen eines Chipkartenmoduls dargestellt, wobei strichliert Detailvarianten angedeutet sind.

Ein zu verkappender Chipkarten-Modul M ist Teil eines Streifens aus mehreren Chipkartenmodulen. Der Modul M besteht aus einem ebenen Träger C, vorzugsweise aus nichtmetallischem Werkstoff, der an seiner in Fig. 1 nach unten weisenden Kontaktoberfläche 9 nicht näher dargestellte, voneinander getrennte Kontaktzonen aufweist. Auf der Oberseite des Trägers C, gegebenenfalls im Bereich eines Fensters, ist ein IC-Baustein 6 angeordnet, der über Leitungen 7 entweder direkt (Durchkontaktierung) mit der Kontaktoberfläche 9 und den dortigen Kontaktzonen verbunden ist, oder mit an der Verkappungsseite angeordneten Kontaktbereichen, die mit den Kontaktzonen elektrisch leitend verbunden sind (nicht gezeigt). Auf dem Modul M wird eine Verkappung 1 einer bestimmten Form und Größe gebildet, die bei der gezeigten Ausführungsform die Form einer gerundeten Kuppe 8 hat, die den IC-Baustein und die Leitungen sowie die verkappungsseitigen Kontaktbereiche einbettet und an der Verkappungsseite am Träger C haftet. Die Verkappung wird aus einer Vergießmasse, zweckmäßigerweise einer strahlungshärtbaren Harzmasse, gebildet, die mit einer Dosiervorrichtung 5 aufgetragen wird.

Die Vorrichtung zum Verkappen weist einen Tisch T auf, der eine ebene Auflagefläche 10 definiert, auf der der Modul in vorbestimmter Position lagegesichert wird, und zwar mittels einer Niederhaltevorrichtung N. Die Niederhaltevorrichtung N weist bei der gezeigten Ausführungsform mechanische, auf- und abbewegbare Niederhalter 12 sowie Ansaugkanäle 11 im Tisch T auf, mit deren Hilfe der aus mehreren Modulen bestehende Streifen und der zu verkappende Modul M an die Auflagefläche 10 gesaugt und lagegesichert wird. Die Ansaugkanäle 11 sind an eine nicht dargestellte Unterdruckquelle angeschlossen und können taktweise beaufschlagt werden. Es ist denkbar, entweder nur die Niederhalter 12 oder nur die Ansaugkanäle 11 vorzusehen.

Unterhalb des Verkappungsbereiches des Moduls M ist im Tisch ein Hohlraum 2, 2a vorgesehen. Ein obenliegender Hohlraumteil 2 ist als flache Vertiefung ausgebildet, deren Umriß einen exakt definierten Ansaugbereich für den Modul begrenzt. Der Hohlraumteil 2 steht mit einem kleineren und nach unten durchgehenden Hohlraumteil 2a in Verbindung, in dem oder unterhalb dessen eine Strahlenquelle 4, z.B. ein UV-Strahler, angeordnet ist, die mit Strahlen 4a die Kontaktoberfläche 9 unterhalb des Verkappungsbereiches beaufschlagt, sobald der Modul M auf die Auflagefläche 10 aufgesetzt ist. An den Hohlraum 2, 2a sind Belüftungskanäle 3 angeschlossen, die entweder zum Druckausgleich eine Verbindung mit der Außenumgebung herstellen oder (strichpunktiert angedeutet) an eine Druckquelle Q angeschlossen sind, um an der Kontaktoberfläche 9 einen exakt vorherbestimmten Überdruck zu erzeugen.

Der Träger C weist zur Kontaktoberfläche 9 durchgängige Öffnungen L auf, die entweder konstruktionsbedingt (für Durchkontaktierungen) oder herstellungsbedingt (Poren, Löcher oder Durchbrüche) vorhanden sind. Die Öffnungen L können unterschiedliche Form, Größe und eine wahlweise Verteilung haben.

Die Dosiervorrichtung 5 ist in Fig. 1 ein taktweise zu öffnendes Dosierventil 5a, das an eine schematisch angedeutete Dosiersteuervorrichtung 13 angeschlossen und mit dieser so betätigbar ist, daß für jede Verkappung eine bestimmte Dosis der Vergießmasse abgegeben wird. Die Vergießmasse kommt aus einem Speicher 14 und liegt in flüssiger Form vor. Das Dosierventil 5a ist (wie durch Pfeile angedeutet) in beliebigen Richtungen verstellbar, um die Vergießmasse in freiem Verguß im Verkappungsbereich aufzutragen, um den IC-Baustein 6 und die Leitungen 7 einzubetten und eine bestimmte Höhe der Verkappung 1einzustellen. Beim Aufbringen der flüssigen Vergießmasse dringt diese auch in die Öffnungen L ein. Durch die Bestrahlung wird die eindringende Vergießmasse jedoch verfestigt und werden die Öffnungen so rasch verschlossen, daß keine Vergießmasse über die Kontaktoberfläche 9 nach unten vordringt oder unkontrolliert durchläuft. Der Tendenz der Vergießmasse, durch die Öffnungen L unter Schwerkrafteinfluß oder durch Kapillarwirkung durchzulaufen, wird ferner durch den an der Kontaktoberfläche 9 eingestellten Druck (Druckgleichgewicht mit der Außenumgebung oder Überdruck) entgegengewirkt. Es kann dabei so vorgegangen werden, daß die Vergießmasse bereits an der oberen Mündung jeder Öffnung L stabilisiert wird, oder nur ein wenig in die Öffnung L einzutreten vermag oder unmittelbar vor dem Austreten an der unteren Mündung verfestigt wird.

Die Strahlenquelle 4 könnte auch an der Verkappungsseite vorgesehen werden. Denkbar ist es ferner, sowohl unterhalb der Auflagefläche 10 als auch oberhalb des Verkappungsbereiches wenigstens eine Strahlenquelle vorzusehen. Ferner könnte im Verkappungsbereich oberhalb des Trägers C ein Unterdruck aufgebaut werden, um der Durchlaufneigung der Vergießmasse entgegenzuwirken.

Verschiedene Verfahrensvarianten sind möglich. Die Dosis an Vergießmasse könnte in einem Zug aufgebracht werden, wobei die in die Öffnungen L eindringende Vergießmasse gleich verfestigt wird. Die Verkappung 1 wird dann an anderer Stelle in üblicher Weise ausgehärtet. Alternativ ist es möglich, zunächst nur eine erste Dosis der Vergießmasse aufzubringen, und die Öffnungen L durch Bestrahlen zu verschließen, und dann erst eine zweite Dosis Vergießmasse aufzubringen, um die endgültige Form der Verkappung herzustellen. Dabei könnte die ersten Dosis relativ klein sein, um nur die Öffnungen zu verschließen. Es ist aber auch denkbar, die erste Dosis bereits so reichlich zu wählen, daß eine Rohverkappung entsteht, deren endgültige Form durch die zweite Dosis realisiert wird. Weiterhin ist es möglich, zwei Dosierventile 5a, 5b zu benutzen und diese aus Vergießmassen-Speichern zu speisen, die unterschiedliche Vergießmassen enthalten. Zum Verschließen der Öffnungen L kann eine zähflüssigere und leicht aushärtende Vergießmasse benutzt werden, während für die zweite Dosis eine dünnflüssigere Vergießmasse benutzt wird, die eine exakte Steuerung der Form und Größe der endgültigen Verkappung ermöglicht. Auch die umgekehrte Vorgangsweise ist denkbar, nämlich zunächst zum Verschließen der Öffnungen die sehr flüssige Vergießmasse einzusetzen und dann mit der zweiten Dosis eine zähflüssige Vergießmasse aufzubringen.

Zur Herstellung einer Verkappung läßt sich eine Taktzeit realisieren, die zwischen einem Bruchteil einer Sekunde bis zu mehreren Sekunden dauert. Die endgültige Aushärtung der Verkappung kann dann über längere Zeit an anderer Stelle durchgeführt werden. Um eine einwandfreie Abdichtung zwischen den Ansaugkanälen 11 und den Belüftungskanälen 3 zu erreichen, und auch um den Modul sicher halten zu können, kann die Auflagefläche 10 mit einer abdichtenden Oberflächenschicht versehen sein, die gleichzeitig eine schonende Behandlung der empfindlichen Kontaktoberfläche 9 garantiert, z.B eine Kunststoffbeschichtung oder dgl.

Wie bereits erwähnt wurde, kann die Verkappung in einem Schritt oder in mehr als einem Schritt aufgebaut werden, wobei jeweils die in die Öffnungen eindringende Vergießmasse so rasch verfestigt wird, daß die Öffnungen L verschlossen werden und keine Vergießmasse nach unten durchläuft. Durch das Bestrahlen mit oder ohne Drucksteuerung wird die eingestellte Dosis der Vergießmasse auch bei Massenproduktion zum Aufbauen der Verkappung mit genau der vorbestimmten Größe und Form verwendet, da keine Vergießmasse unkontrolliert verloren geht. Beim mehrstufigen Ausbilden der Verkappung wird eine besonders hohe Präzision der Verkappung erreicht, insbesondere wenn dazu Vergießmassen mit unterschiedlichen Einstellungen benutzt werden .Als zusätzlich wünschenswerter Effekt ergibt sich eine sehr wirkungsvolle formschlüssige Verzahnung der Verkappung mit dem Träger C, weil die nur gesteuert in die Öffnungen eingedrungene Vergießmasse darin verankert wird. Dies erhöht den Widerstand der Verkappung gegen Ablösen vom Träger in den bei Biegebelastungen kritischen Randbereichen der Verkappung.

Zweckmäßigerweise werden Vergießmassen mit einer Dichte bis zu 1,5 g/cm³ für Verkappungen mit geringer Höhe benutzt. Bei höheren Verkappungen und Trägern mit Öffnungen und großen Durchmessern sind hingegen Vergießmassen mit Dichten > 1,5 g/cm³ zweckmäßig. Die Viskosität sollte größer als 4000 mPas sein, zweckmäßigerweise zwischen 10000 bis 30000 mPas liegen.

## Patentansprüche

1. Verfahren zum einseitigen Verkappen eines Chipkartenmoduls (M) mit bei dosierter Aufbringungflüssiger undhärtbarerVergießmasse, wobei der Chipkartenmodul (M) eine Kontaktoberfläche (9), wenigstens einen IC-Baustein (6) und den IC-Baustein mit der Kontaktoberfläche verbindende Leitungen (7) sowie im Verkappungsbereich zur Kontaktoberfläche durchgängige Öffnungen (L) aufweist, **dadurch gekennzeichnet, daß** in die Öffnungen (L) eindringende, flüssige Vergießmasse unter Verschließen der Öffnungen (L) durch Bestrahlen mit UV-Strahlen verfestigt und am Austreten aus den zur Kontaktoberfläche offenen Mündungen der Öffnungen (L) gehindert wird, und daß beim Bestrahlen mit UV-Strahlen der an der Kontaktoberfläche (9) herrschende Druck und der an der Verkappungsseite herrschende Druck derart eingestellt werden, daß sich entweder ein Druckgleichgewicht oder an der Kontaktoberfläche ein Überdruck ergibt.

2. Verfahren nach Anspruch 1, **dadurch gekennzeichnet, daß** zum Verschließen der Öffnungen (L) eine erste Dosis Vergießmasse aufgebracht wird, und daß nach dem oder beim Verschließen der Öffnungen (L) wenigstens eine zweite Dosis Vergießmasse aufgebracht wird.

3. Verfahren nach einem der vorhergehenden Ansprüche, **dadurch gekennzeichnet, daß** in die Öffnungen (L) eindringende Vergießmasse von der Seite der Kontaktoberfläche (9) des Trägers her bestrahlt wird.

4. Verfahren nach einem der Ansprüche 1 bis 3, **dadurch gekennzeichnet, daß** mit UV-Strahlen einer auf das Polymerisationsverhalten der Vergießmasse abgestimmten Wellenlänge bestrahlt wird.

5. Vorrichtung zum einseitigen Verkappen von Chipkartenmodulen (M) mit einer bei der Aufbringung flüssigen und härtbaren Vergießmasse, wobei jeder Chipkartenmodul (M) einen ebenen Träger (C) mit einer Kontaktoberfläche (9), wenigstens einem IC-Baustein (6) und den IC-Baustein mit der Kontaktoberfläche verbindende Leitungen (7) aufweist, und im Verkappungsbereich zur Kontaktoberfläche durchgängige Öffnungen (L) besitzt, mit einer Auflagefläche (10) zum positionierten Lagesichern des Trägers (C) und mit wenigstens einer Dosiervorrichtung zum Aufbringen von Vergießmasse auf den Verkappungsbereich, **dadurch gekennzeichnet, daß** in der Auflagefläche (10) unterhalb des Verkappungsbereiches eines mit der Kontaktoberfläche (9) auf der Auflagefläche (10) positionierbaren Trägers (C) ein Hohlraum (2, 2a) vorgesehen ist, daß wenigstens eine auf den Träger (C) ausrichtbare UV-Strahlenquelle (4) vorgesehen ist, mit der zumindest die in die Öffnungen (L) eingedrungene Vergießmasse aushärtende UV-Strahlen (4a) erzeugbar sind, und daß der Hohlraum (2, 2a) über wenigstens einen Belüftungskanal (3) mit der Umgebungsluft oder mit einer Druckquelle (Q) verbunden ist.

6. Vorrichtung nach Anspruch 5, **dadurch gekennzeichnet, daß** die Strahlenquelle (4) unterhalb der Auflagefläche (10) positioniert und im Hohlraum (2, 2a) auf den Träger (C) ausgerichtet ist.

7. Vorrichtung nach Anspruch 6, **dadurch gekennzeichnet, daß** die UV-Strahlenquelle (4), eine im oder angrenzend an den Hohlraum (2, 2a) vorgesehene UV-Lichtquelle ist.

8. Vorrichtung nach einem der Ansprüche 5 bis 7, **dadurch gekennzeichnet, daß** der Hohlraum (2, 2a) der Kontaktoberfläche (9) abgewandt verschlossen ist.

9. Vorrichtung nach einem der Ansprüche 5 bis 8, **dadurch gekennzeichnet, daß** eine Niederhaltevorrichtung (N) für den Träger (C) vorgesehen ist, die von oben absenkbare Niederhalter (12) oder/und außerhalb des Hohlraums (2, 2a) zur Auflagefläche (10) führende Saugkanäle (11) aufweist.

10. Vorrichtung nach Anspruch 5, **dadurch gekennzeichnet, daß** wenigstens ein Dosierventil (5a, 5b) für flüssige Vergießmasse oberhalb der Auflagefläche (10) vorgesehen ist, das mit einer Dosiersteuervorrichtung (13) zum jeweils aufeinanderfolgenden Abgeben einer ersten Dosis und einer zweiten Dosis in Verbindung steht.

11. Vorrichtung nach Anspruch 5, **dadurch gekennzeichnet, daß** ein erstes Dosierventil (5a) für jeweils eine erste Dosis und ein zweites Dosierventil (5b) für jeweils eine zweite Dosis an Vergießmasse vorgesehen sind.

12. Vorrichtung nach Anspruch 11, **dadurch gekennzeichnet, daß** die ersten und zweiten Dosierventile (5a, 5b) aus ersten und zweiten Vergießmasse-Speichem (14) speisbar sind, und daß die beiden Speicher Vergießmassen mit unterschiedlichen Einstellungen und/oder Viskositäten und/oder Härtungseigenschaften enthalten.

## Claims

1. Method for the single-sided encapsulation of a chip card module (M) with potting compound which is liquid and curable when applied in a metered fashion, wherein the chip card module (M) comprises a contact surface (9), at least one IC component (6) and leads (7), which connect the IC component to the contact surface, as well as openings (L) passing through to the contact surface in the encapsulation region, **characterised in that** liquid potting compound penetrating into the openings (L) is solidified while sealing the openings (L) through irradiation with UV rays and is prevented from leaving the mouths, which are open towards the contact surface, of the openings (L), and that the pressure prevailing at the contact surface (9) and the pressure prevailing at the encapsulation side are set upon irradiation with UV rays so as to produce either a pressure equilibrium or, at the contact surface, an overpressure.

2. Method according to Claim 1, **characterised in that** a first dose of potting compound is applied to seal the openings (L), and that at least a second dose of potting compound is applied subsequent to or during sealing of the openings (L).

3. Method according to any one of the preceding Claims, **characterised in that** potting compound penetrating into the openings (L) is irradiated from the side of the contact surface (9) of the carrier.

4. Method according to any one of Claims 1 to 3, **characterised in that** irradiation is carried out with UV rays of a wavelength adapted to the polymerisation behaviour of the potting compound.

5. Device for the single-sided encapsulation of chip card modules (M) with a potting compound which is liquid and curable when applied, wherein each chip card module (M) comprises a plane carrier (C) with a contact surface (9), at least one IC component (6) and leads (7), which connect the IC component to the contact surface, and has openings (L) passing through to the contact surface in the encapsulation region, with a support face (10) for securing the position of the carrier (C) and with at least one metering device for applying potting compound to the encapsulation region, **characterised in that** a cavity (2, 2a) is provided in the support face (10) below the encapsulation region of a carrier (C), which can be positioned with the contact surface (9) on the support face (10), that at least one UV radiation source (4) is provided which can be directed at the carrier (C) and with which UV rays (4a) curing at least the potting compound having penetrated into the openings (L) can be produced, and that the cavity (2, 2a) communicates with the ambient air or with a pressure source (Q) via at least one ventilation duct (3).

6. Device according to Claim 5, **characterised in that** the radiation source (4) is positioned below the support face (10) and directed at the carrier (C) in the cavity (2, 2a).

7. Device according to Claim 6, **characterised in that** the UV radiation source (4) is a UV light source provided in or adjacent to the cavity (2, 2a).

8. Device according to any one of Claims 5 to 7, **characterised in that** the cavity (2, 2a) is sealed remotely from the contact surface (9).

9. Device according to any one of Claims 5 to 8, **characterised in that** a holding-down device (N) for the carrier (C) is provided, which device comprises hold-down units (12), which can be lowered from above, or/and suction ducts (11) leading to the support face (10) outside of the cavity (2, 2a).

10. Device according to Claim 5, **characterised in that** at least one metering valve (5a, 5b) for liquid potting compound is provided above the support face (10), which valve is connected to a metering control device (13) for delivering a first dose and a second dose in succession.

11. Device according to Claim 5, **characterised in that** a first metering valve (5a) for a first respective dose and a second metering valve (5b) for a second respective dose are provided.

12. Device according to Claim 11, **characterised in that** the first and second metering valves (5a, 5b) can be fed from first and second potting compound stores (14), and that the two stores contain potting compounds with different settings and/or viscosities and/or curing properties.

## Revendications

1. Procédé pour l'encapsulation unilatérale d'un module de carte à puce (M) avec une masse de moulage liquide et durcissable appliquée de manière dosée, le module de carte à puce (M) présentant une surface de contact (9), au moins un circuit intégré (6), des conducteurs (7) reliant le circuit intégré à la surface de contact ainsi que dans la zone d'encapsulation, des orifices (L) communiquant avec la surface de contact, **caractérisé en ce que** l'on empêche la masse de moulage liquide, qui pénètre dans les orifices (L) en les obturant, de sortir des orifices (L) ouverts vers la surface de contact, en la faisant durcir en l'exposant à des rayons ultraviolets, et que lors de l'exposition aux rayons ultraviolets, on règle la pression régnant sur la surface de contact (9) ou la pression régnant sur le côté de l'encapsulation de telle sorte que l'on obtient soit un équilibre de pression soit une surpression au niveau de la surface de contact.

2. Procédé selon la revendication 1, **caractérisé en ce que** pour obturer les orifices (L), on applique une première dose de masse de moulage et qu'on applique au moins une seconde dose de masse de moulage après l'obturation des orifices (L) ou lors de celle-ci.

3. Procédé selon une des revendications précédentes, **caractérisé en ce que** la masse de moulage qui a pénétré dans les orifices (L) est exposée aux rayons à partir du côté de la surface de contact (9) du support.

4. Procédé selon une des revendications 1 à 3, **caractérisé en ce que** l'on pratique l'exposition avec des rayons ultraviolets d'une longueur d'onde adaptée au comportement de polymérisation de la masse de moulage.

5. Dispositif pour l'encapsulation unilatérale de modules de carte à puce (M) avec une masse de moulage liquide et durcissable lors de l'application, chaque module de carte à puce (M) présentant un support (C) plat avec une surface de contact (9), au moins un circuit intégré (6) et des conducteurs (7) reliant le circuit intégré à la surface de contact, et possédant dans la zone d'encapsulation, des orifices (L) communiquant avec la surface de contact, avec une surface d'appui (10) pour bloquer en position le support (C) et avec au moins un dispositif de dosage pour appliquer une masse de moulage sur la zone d'encapsulation, **caractérisé en ce qu'**une cavité (2, 2a) est prévue dans la surface d'appui (10), au-dessous de la zone d'encapsulation d'un support (C) pouvant être positionné sur la surface d'appui (10) avec la surface de contact (9), qu'il est prévu au moins une source de rayons ultraviolets (4) qui peut être dirigée sur le support (C) et peut produire des rayons ultraviolets (4a) faisant durcir au moins la masse de moulage pénétrée dans les orifices (L) et que la cavité (2, 2a) est reliée par au moins un canal d'aération (3) avec l'air ambiant ou avec une source de pression (Q).

6. Dispositif selon la revendication 5, **caractérisé en ce que** la source de rayons (4) est positionnée au-dessous de la surface d'appui (10) et est dirigée dans la cavité (2, 2a) sur le support (C).

7. Dispositif selon la revendication 6, **caractérisé en ce que** la source de rayons ultraviolets (4) est une source de lumière ultraviolette prévue dans la cavité (2, 2a) ou au voisinage de celle-ci.

8. Dispositif selon une des revendications 5 à 7, **caractérisé en ce que** la cavité (2, 2a) est fermée à l'opposé de la surface de contact (9).

9. Dispositif selon une des revendications 5 à 8, **caractérisé en ce qu'**il est prévu un dispositif de maintien (N) pour le support (C) qui comporte des dispositifs presseurs (12) pouvant être abaissés par le haut ou/et, à l'extérieur de la cavité (2, 2a), des canaux d'aspiration (11) menant à la surface d'appui (10).

10. Dispositif selon la revendication 5, **caractérisé en ce qu'**il est prévu au-dessus de la surface d'appui (10), au moins une vanne de dosage (5a, 5b) pour une masse de moulage liquide, laquelle vanne communique avec un dispositif de commande de dosage (13) pour délivrer successivement une première dose et une seconde dose.

11. Dispositif selon la revendication 5, **caractérisé en ce qu'**il est prévu une première vanne de dosage (5a) pour une première dose et une seconde vanne de dosage (5b) pour une seconde dose de masse de moulage.

12. Dispositif selon la revendication 11, **caractérisé en ce que** les première et seconde vannes de dosage (5a, 5b) peuvent être alimentées à partir de première et de seconde réserves (14) de masse de moulage et que les deux réserves contiennent des masses de moulage avec des réglages et/ou des viscosités et/ou des propriétés de durcissement différents.
